# EUROPEAN PATENT APPLICATION

(11) **EP 4 321 648 A1**
(43) Date of publication of application: **14.02.2024**
(21) Application number: 22784027.9
(22) Date of filing: 06.04.2022
(51) Int. Cl.: C23C 16/455, C23C 16/52

(54) **PLASMA ENHANCED ATOMIC LAYER DEPOSITION APPARATUS AND METHOD**

(30) Priority: 09.04.2021 CN 202110380765
(71) Applicant: Beijing NAURA Microelectronics Equipment Co., Ltd., Beijing 100176 (CN)
(72) Inventor: QIN, Haifeng, Beijing 100176 (CN); ZHENG, Bo, Beijing 100176 (CN); SHI, Xiaoping, Beijing 100176 (CN); LAN, Yunfeng, Beijing 100176 (CN); ZHANG, Wenqiang, Beijing 100176 (CN); WANG, Hao, Beijing 100176 (CN); REN, Xiaoyan, Beijing 100176 (CN)
(74) Representative: Cohausz & Florack
(86) International application number: PCT/CN2022/085234
(87) International publication number: WO 2022/213961

(57) **Abstract**

Embodiments of the present disclosure provide a plasma-enhanced atomic layer deposition apparatus and a method thereof. The apparatus includes a precursor supply device communicating with gas inlet structures of two process chambers and configured to selectively provide a precursor or a purge gas to at least one of the two process chambers, a reaction gas supply device communicating with the gas inlet structures of the two process chambers and configured to selectively provide a reaction gas to at least one of the two process chambers, a radio frequency device connected to the two process chambers and configured to selectively output radio frequency power to at least one of the two process chambers, and a pressure adjustment device communicating with exhaust openings of the two process chambers and configured to independently control chamber pressures of the two process chambers. With the plasma-enhanced atomic layer deposition apparatus and the method thereof of embodiments of the present disclosure, process adjustment manners are increased, and the precursor supply device does not need to be provided for each of the process chambers. Thus, the apparatus costs can be reduced.

## Description

### TECHNICAL FIELD

The present disclosure generally relates to the semiconductor manufacturing field and, more particularly, to a plasma-enhanced atomic layer deposition apparatus and a method thereof.

### BACKGROUND

Atomic Layer Deposition (ALD) as a method for depositing thin films has advantages such as good conformality, precise thickness control, and outstanding coverage capability for pattern structures with high depth-to-width ratios. Plasma-enhanced Atomic Layer Deposition (PEALD) is a good complement to the ALD method which can be used to avoid a relatively high process temperature, and broaden the selection range of a precursor.

However, both an ALD apparatus and a PEALD apparatus have a problem of low productivity. To improve the productivity of the PEALD apparatus, an existing method includes using two process chambers to simultaneously process two wafers. However, in addition to meeting the process requirement in each process chamber, a requirement is imposed on process repeatability between the two process chambers (including film thickness and thickness uniformity, film density, etc.). For example, a difference in thicknesses of films deposited simultaneously in the two process chambers is smaller than a specified threshold (e.g., less than 1 angstrom).

However, the existing PEALD apparatus with two process chambers inevitably faces the following problems in practical applications.

First, the chamber pressure and radio frequency-related parameters of the two process chambers cannot be independently controlled which limits the process adjustment. For example, when the difference exists between the film thicknesses deposited in the two process chambers, the difference cannot be eliminated by independently adjusting the chamber pressure and the radio frequency-related parameters (such as radio frequency power, frequency, and ignition time) of the process chambers, thereby reducing the flexibility of the process adjustment manner.

Secondly, the two process chambers have to simultaneously perform plasma reaction steps, which causes other steps (such as precursor introduction and purging) to be performed simultaneously as well and causes a single process manner. Moreover, matching performance between the process chambers becomes poor. To introduce the precursor simultaneously into the two process chambers, an individual precursor source (e.g., a source bottle) needs to be provided for each chamber, which increases the cost of the precursor source and the complexity of the chamber structure.

### SUMMARY

The present disclosure aims to address at least one technical problem existing in the existing technology and provides a plasma-enhanced atomic layer deposition apparatus and a method thereof. Chamber pressures and radio frequency-related parameters of the process chambers can be independently adjusted, which increases the process adjustment manner and improves the process compatibility and the process versatility. Moreover, the precursor supply device does not need to be provided for each chamber, which reduces the apparatus costs.

To realize the purpose of the present disclosure, a plasma-enhanced atomic layer deposition apparatus is provided. The apparatus includes two process chambers, a precursor supply device, a reaction gas supply device, a radio frequency device, and a pressure adjustment device.

The precursor supply device communicates with gas inlet structures of the two process chambers and is configured to selectively provide a precursor or a purge gas to at least one of the two process chambers.

The reaction gas supply device communicates with the gas inlet structures of the two process chambers and is configured to selectively provide a reaction gas to at least one of the two process chambers.

The radio frequency device is connected to the two process chambers and is configured to selectively output radio frequency power to at least one of the two process chambers.

The pressure adjustment device communicates with exhaust openings of the two process chambers and is configured to independently control chamber pressures of the two process chambers.

In some embodiments, the precursor supply device includes a precursor source, a gas inlet pipeline group, a switching pipeline group, and a gas pump device. The precursor source communicates with the gas inlet pipeline group through the switching pipeline group, and the gas inlet pipeline group communicates with the gas inlet structures of the two process chambers.

The precursor source is configured to provide the precursor or purge gas.

The switching pipeline group is configured to selectively communicate the precursor source to the gas inlet pipeline group or the gas pump device.

The gas inlet pipeline assembly is configured to selectively communicate the precursor source to at least one of the two process chambers.

In some embodiments, the gas inlet pipeline group includes a first gas inlet branch and a second gas inlet branch. A gas outlet end of the first gas inlet branch and a gas outlet end of the second gas inlet branch communicate with the gas inlet structures of the two process chambers, respectively. A gas inlet end of the first gas inlet branch and a gas inlet end of the second gas inlet branch communicate with the switching pipeline group. A first on-off valve and a second on-off valve are arranged at the first gas inlet branch and the second gas inlet branch, respectively.

In some embodiments, the gas inlet pipeline group further includes a first dilution branch and a second dilution branch. Gas inlet ends of the first dilution branch and the second dilution branch communicate with a dilution gas source configured to provide the dilution gas, respectively. Gas outlet ends of the first dilution branch and the second dilution branch communicate with a first gas inlet branch and a second gas inlet branch, respectively. A first flow controller and a second flow controller are arranged at the first dilution branch and the second dilution branch.

In some embodiments, the gas inlet pipeline group further includes two gas mixing structures. Each of the two mixing structures has a first gas inlet end, a second gas inlet end, and a gas outlet end. The first gas inlet ends of the two mixing structures communicate with the gas outlet ends of the first gas inlet branch and the second gas inlet branch. The gas outlet ends of the two gas mixing structures communicate with the gas inlet structures of the two process chambers, respectively. The second gas inlet ends of the two gas mixing structures communicate with a balance gas source configured to provide a balance gas and a reaction gas supply device, respectively.

In some embodiments, each of the mixing structures includes a gas mixing block and a gas mixing pipeline. The gas mixing block has a mixing chamber, and the first gas inlet end and the second gas inlet end are formed on an outer surface of the gas mixing block. A gas outlet end is formed on the outer surface of the gas mixing block. The gas outlet end communicates with a gas inlet end of the gas mixing pipeline. The gas outlet end of the gas mixing pipeline is used as the gas outlet end of the gas mixing structure to communicate with the gas inlet structure of the process chamber.

In some embodiments, the switching pipeline group includes a first switching branch and a second switching branch. Two ends of the first switching branch communicate with the precursor source and the gas inlet pipeline group, respectively. Two ends of the second switching branch communicate with the first switching branch and the gas pump device. A third on-off valve and a fourth on-off valve are arranged at the first switching branch and the second switching branch.

In some embodiments, the precursor source includes a carrier gas main route, a source bottle, a first carrier gas branch, and a second carrier gas branch. A gas inlet end of the carrier gas main route communicates with a carrier gas source for providing a carrier gas. A gas outlet end of the carrier gas main route communicates with the switching pipeline group. A fifth on-off valve and a third flow controller are arranged at the carrier gas main route.

A gas inlet end of the first carrier gas branch communicates with the carrier gas main route at an upstream position of the fifth on-off valve. A gas outlet end of the first carrier gas branch communicates with a gas inlet end of the source bottle. A gas outlet end of the second carrier gas branch communicates with the carrier gas main route at a downstream position of the fifth on-off valve. A gas inlet end of the second carrier gas branch communicates with the gas outlet end of the source bottle. A sixth on-off valve and a seventh on-off valve are arranged at the first carrier gas branch and the second carrier gas branch.

The source bottle is configured to store the precursor.

In some embodiments, the radio frequency device includes a first matcher, a second matcher, a first radio frequency generator, and a second radio frequency generator. The first radio frequency generator is electrically connected to one of the process chambers through the first matcher. The second radio frequency generator is electrically connected to the other one of the process chambers through the second matcher.

In some embodiments, the pressure adjustment device includes a first exhaust branch and a second exhaust branch. Gas inlet ends of the first exhaust branch and the second exhaust branch communicate with exhaust openings of the two process chambers, respectively. Gas outlet ends of the first exhaust branch and the second exhaust branch communicate with the gas pump device. A first isolation valve and a second isolation valve are arranged at the first exhaust branch and the second exhaust branch, respectively. A first flow adjustment valve and a second flow adjustment valve are arranged at the first exhaust branch and the second exhaust branch.

In some embodiments, the plasma-enhanced atomic layer deposition apparatus further includes a remote plasma cleaning device, a first cleaning pipeline, and a second cleaning pipeline. Each of the two gas mixing structures includes a third gas inlet end, gas inlet ends of the first cleaning pipeline and the second cleaning pipeline communicate with the remote plasma cleaning device. Gas outlet ends of the first cleaning pipeline and the second cleaning pipeline communicate with the two third gas inlet ends. A third isolation valve and a fourth isolation valve are arranged at the first cleaning pipeline and the second cleaning pipeline, respectively.

The remote plasma cleaning device is configured to provide a plasma for cleaning the process chamber.

As another technical solution, embodiments of the present disclosure further provide a plasma-enhanced atomic layer deposition method. The plasma-enhanced atomic layer deposition apparatus of embodiments of the present disclosure is used to simultaneously deposit film layers on two wafers. The plasma-enhanced atomic layer deposition method includes:
at S1, introducing the precursor into a first process chamber of the two process chambers, introducing the reaction gas into a second process chamber of the two process chambers, and applying the radio frequency power to the second process chamber;
at S2, purging the precursor supply device and the two process chambers;
at S3, introducing the precursor into the second process chamber, introducing the reaction gas into the first process chamber, and applying the radio frequency power to the first process chamber;
at S4, purging the precursor supply device and the two process chambers; and
repeating steps S1 to S4 in a cycle until the thicknesses of the deposited film layers on the two wafers reach a target thickness.

The present disclosure includes the following beneficial effects.

In the plasma-enhanced atomic layer deposition method of embodiments of the present disclosure, the pressure adjustment device that communicates with the exhaust openings of the two process chambers can be used to control the chamber pressures of the two process chambers independently. Moreover, the radio frequency device that is connected to the two process chambers can be configured to selectively output the radio frequency power to the at least one process chamber of the two process chambers. The radio frequency-related parameters of the process chambers can be independently adjusted. Thus, the process adjustment manner can be increased, the process compatibility can be improved, and the process steps do not need to be performed simultaneously in the two process chambers. Therefore, the process versatility can be improved, and the precursor supply device does not need to be provided for each chamber. That is, the precursor supply device communicates with the gas inlet structures of the two process chambers to selectively provide the precursor or the purge gas to the at least one process chamber of the two process chambers, thereby reducing the apparatus costs.

### BRIEF DESCRIPTION OF THE DRAWINGS

FIG. 1A illustrates a schematic structural diagram of an existing plasma-enhanced atomic layer deposition apparatus.
FIG. 1B illustrates a schematic flowchart of a deposition method using the plasma-enhanced atomic layer deposition apparatus in FIG. 1A.
FIG. 2 illustrates a schematic principle block diagram of a plasma-enhanced atomic layer deposition apparatus according to an embodiment of the present disclosure.
FIG. 3 illustrates a schematic structural diagram of a plasma-enhanced atomic layer deposition apparatus according to an embodiment of the present disclosure.
FIG. 4 illustrates a schematic enlarged diagram of a precursor source according to an embodiment of the present disclosure.
FIG. 5 illustrates a schematic enlarged diagram of a gas inlet pipeline group according to an embodiment of the present disclosure.
FIG. 6 illustrates a schematic flowchart of a plasma-enhanced atomic layer deposition method according to an embodiment of the present disclosure.
FIG. 7 illustrates another schematic flowchart of a plasma-enhanced atomic layer deposition method according to an embodiment of the present disclosure.

### DETAILED DESCRIPTION OF THE EMBODIMENTS

Embodiments of the present disclosure are described in detail in connection with the accompanying drawings. It should be understood that the specific embodiments described here are merely used for illustrating and explaining the present disclosure and are not intended to limit the scope of the present disclosure.

To cause those skilled in the art better understand the technical solutions of the present disclosure, the plasma-enhanced atomic layer deposition apparatus and the method thereof of embodiments of the present disclosure are described in detail in connection with the accompanying drawings.

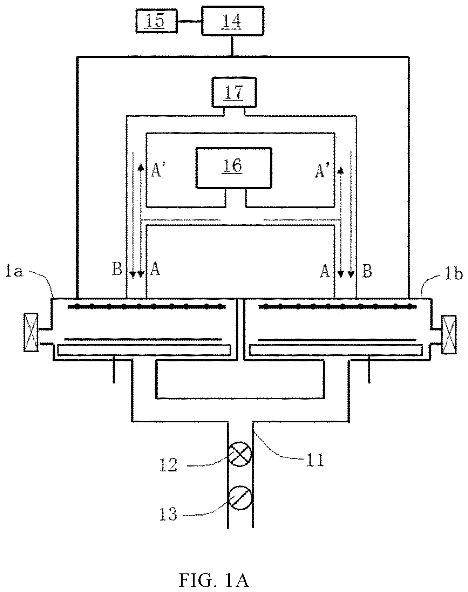

As shown in FIG. 1A, an existing plasma-enhanced atomic layer deposition (PEALD) apparatus includes two process chambers (1a, 1b) configured to simultaneously perform deposition processes on wafers. Exhaust gases from the two process chambers (1a, 1b) are collected into a main exhaust pipe 11 and transported to an exhaust device (not shown) through the main exhaust pipe 11. Moreover, an isolation valve 12 and a flow control valve 13 are arranged on the main exhaust pipe 11. The isolation valve 12 is configured to open or close the main exhaust pipe 11. The flow control valve 13 is configured to adjust a gas inlet volume in the main exhaust pipe 11 to control the gas pressures in the two process chambers (1a, 1b) simultaneously.

Furthermore, the two process chambers (1a, 1b) are connected to a gas supply device 16 and a remote plasma cleaning device 17 through their respective gas inlet pipes. The gas supply device 16 is configured to provide a process gas (including, but not limited to, a precursor, a reaction gas, and a purge gas) to the two process chambers (1a, 1b) simultaneously. The remote plasma cleaning device 17 is configured to provide a plasma (such as a plasma formed by ionizing NF3 gas) capable of cleaning the process chamber simultaneously after the films in the two process chambers (1a, 1b) reach a certain thickness.

Moreover, the two process chambers (1a, 1b) share a matcher 14 and a radio frequency generator 15. The radio frequency generator 15 is configured to apply the radio frequency power to the two process chambers (1a, 1b) simultaneously through the matcher 14 to excite the reaction gas in the two process chambers (1a, 1b) to generate the plasma.

The above PEALD apparatus can inevitably have the following issues in practical applications.

Firstly, since the two process chambers (1a, 1b) share the isolation valve 12 and the flow control valve 13, the chamber pressures of the two process chambers (1a, 1b) cannot be independently controlled, which limits the process adjustment. For example, when the difference exists in the thicknesses of the films deposited in the two process chambers, the difference cannot be eliminated by independently adjusting the chamber pressures of the process chambers, which reduces the flexibility of the process adjustment manner. In addition, when the isolation valve 12 is opened, the two process chambers (1a, 1b) can communicate with each other through the exhaust pipeline. Thus, real physical isolation is not realized. When one process chamber has an abnormal situation such as fragmentation or an increase in particle count, the other process chamber can be negatively affected.

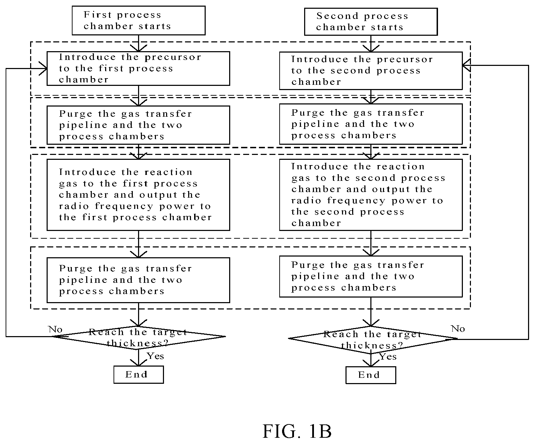

Secondly, since the two process chambers (1a, 1b) share the matcher 14 and the radio frequency generator 15, the difference cannot be eliminated by independently adjusting the radio frequency-related parameters (such as power, frequency, ignition time, etc.) of the process chambers when the difference exists in the thicknesses of the films deposited in the two process chambers. Meanwhile, as shown in FIG. 1B, since the plasma reaction steps have to be performed simultaneously in the two process chambers (1a, 1b), the other steps (precursor introduction, purging, etc.) have to be performed simultaneously too, which results in a single process manner, and the process matching capability between the chambers can become poor. Moreover, to cause the two process chambers to meet the process matching requirement, an individual precursor source (e.g., a source bottle) needs to be provided for each process chamber to simultaneously introduce the precursor into the two process chambers, which increases the cost of the precursor source and the complexity of the chamber structure.

Thirdly, since no switching control structure is provided between the two process chambers (1a, 1b) and the remote plasma cleaning device 17, cleaning can only be performed simultaneously on the two process chambers (1a, 1b) and cannot be performed independently, which causes a single cleaning manner. Moreover, since the remote plasma cleaning device 17 and the gas supply device 16 share the same gas inlet pipeline and are not physically isolated, the risk that the process gas diffuses toward the remote plasma cleaning device 17 can exist to increase the difficulty of process control can be increased.

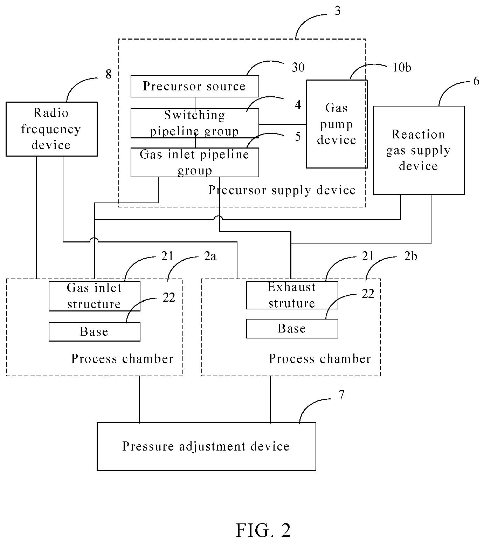

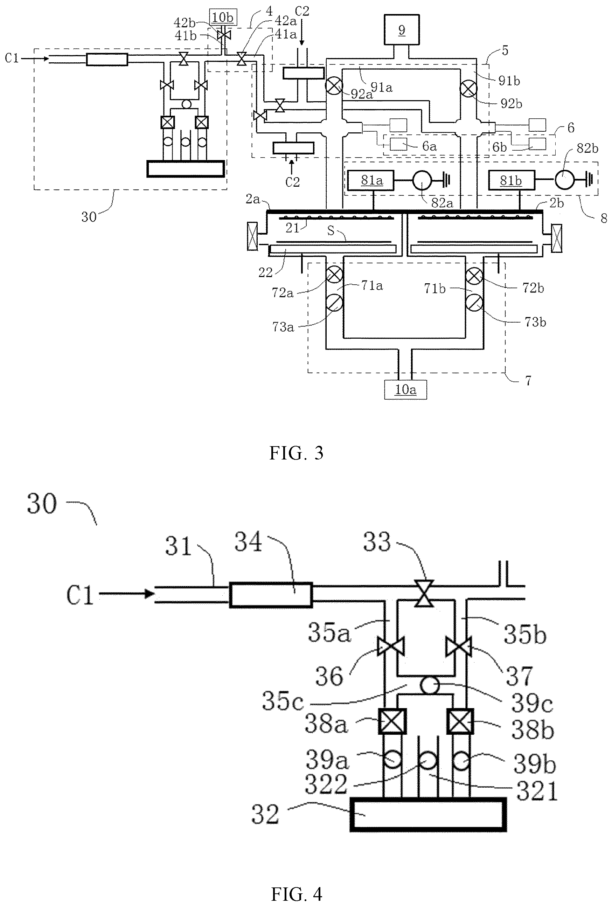

To solve at least one of the above problems of the PEALD apparatus, please also refer to FIG. 2 and FIG. 3. Embodiments of the present disclosure provide a plasma-enhanced atomic layer deposition (PEALD) apparatus. The apparatus includes two process chambers (2a, 2b), a precursor supply device 3, a reaction gas supply device 6, a radio frequency device 8, and a pressure adjustment device 7. The two process chambers (2a, 2b) are independent chambers that are physically isolated. Each of the two process chambers includes a gas inlet structure 21. The gas inlet structure 21, for example, is a gas distribution device arranged at the top of the chamber and configured to transfer the process gas uniformly into the chamber. Moreover, a base 22 is arranged in each of the process chambers and configured to carry wafer S and control the temperature of wafer S.

The precursor supply device 3 is connected to the gas inlet structures 21 of the two process chambers (2a, 2b) and is configured to selectively provide the precursor or the purge gas to at least one of the two process chambers (2a, 2b). That is, the two process chambers (2a, 2b) share one precursor supply device 3. In practical applications, the precursor can be selected according to the composition and characteristics of the to-be-deposited film material. The precursor can be transferred into the process chamber in a gaseous form with or without a carrier gas. For example, if the to-be-deposited film material can be silicon dioxide (SiO2), and SAM24 (diethylaminosilane) can be selected as the precursor.

In some embodiments, optionally, the precursor supply device 3 includes a precursor source 30, a gas inlet pipeline group 5, a switching pipeline group 4, and an exhaust device 10b. The precursor source 30 communicates with the gas inlet pipeline group 5 through the switching pipeline group 4. The gas inlet pipeline group 5 communicates with the gas inlet structures 21 of the two process chambers (2a, 2b). The precursor source 30 can be configured to provide the above precursor or the purge gas. The switching pipeline group 4 can be configured to selectively communicate the precursor source 30 with the gas inlet pipeline assembly 5 or the exhaust device 10b. The gas inlet pipeline assembly 5 can be configured to selectively communicate the precursor source 30 with at least one of the two process chambers (2a, 2b).

When the switching pipeline group 4 communicates the precursor source 30 with the gas inlet pipeline assembly 5, the precursor provided by the precursor source 30 can be transferred into the gas inlet pipeline group 5 and transferred to at least one of the two process chambers (2a, 2b) through the gas inlet pipeline group 5. When the switching pipeline group 4 communicates the precursor source 30 with the exhaust device 10b, the precursor provided by the precursor source 30 can be directly exhausted into the exhaust device 10b without flowing through any process chamber.

In some embodiments, as shown in FIG. 3, the switching pipeline group 4 includes a first switching branch 41a and a second switching branch 41b. Two ends of the first switching branch 41a communicate with the precursor source 30 and the gas supply pipeline group 5, respectively. Two ends of the second switching branch 41b communicate with the first switching branch 41a and the exhaust device 10b, respectively. Moreover, a third on-off valve 42a and a fourth on-off valve 42b are arranged at the first switching branch 41a and the second switching branch 41b, respectively. When the third on-off valve 42a is on, and the fourth on-off valve 42b is off, the first switching branch 41a is connected, and the second switching branch 41b is disconnected. Thus, the precursor output by the precursor source 30 can flow into the gas inlet pipeline group 5 through the first switching branch 41a. When the third on-off valve 42a is off, and the fourth on-off valve 42b is on, the first switching branch 41a is disconnected, and the second switching branch 41b is connected. Thus, the precursor output by the precursor source 30 can flow into the exhaust device 10b through the second switching branch 41b.

In some embodiments, as shown in FIG. 4, the precursor source 30 includes a carrier gas main route 31, a source bottle 32, a first carrier gas branch 35a, and a second carrier gas branch 35b. A gas inlet end of the carrier gas main route 31 (facing left in FIG. 4) communicates with a carrier gas source (not shown in the figure) for providing carrier gas C1. A gas outlet end (facing right in FIG. 4) of the carrier gas main route 31 communicates with the switching pipeline group 4 (i.e., the gas inlet end of the first switching branch 41a shown in FIG. 3). Moreover, a fifth on-off valve 33 and a third mass flow rate controller 34 can be arranged at the carrier gas main route 31. The fifth on-off valve 33 can be configured to connect or disconnect the carrier gas main route 31. The third mass flow rate controller 34 can be configured to control the flow rate of carrier gas C1 of the carrier gas main route 31.

The gas inlet end of the first carrier gas branch 35a communicates with the carrier gas main route 31 at an upstream position of the fifth on-off valve 33. The gas outlet end of the carrier gas branch 35a communicates with the gas inlet end of the source bottle 32. The gas outlet end of the second carrier gas branch 35b communicates with the carrier gas main route 31 at a downstream position of the fifth on-off valve 33. The gas inlet end of the second carrier gas branch 35b communicates with the gas outlet end of the source bottle 32. Moreover, a sixth on-off valve 36 and a seventh on-off valve 37 are arranged at the first carrier gas branch 35a and the second carrier gas branch 35b, respectively. The sixth on-off valve 36 can be configured to connect or disconnect the first carrier gas branch 35a. The seventh on-off valve 37 can be configured to connect or disconnect the second carrier gas branch 35b.

The source bottle 32 can be configured to store the precursor. An initial state of the precursor stored in the source bottle 32 can be liquid, solid, or gaseous. During the process, the precursor in the source bottle 32 can be outputted in the gaseous form with or without the carrier gas. In some embodiments, when the fifth on-off valve 33 is on, and the sixth on-off valve 36 and the seventh on-off valve 37 are off, the carrier gas main route 31 can be connected, and the first carrier gas branch 35a and the second carrier gas branch 35b can be disconnected. Thus, carrier gas C1 can flow to the switching pipeline group 4 through the carrier gas main route 31 not through the source bottle 32. That is, the precursor in the source bottle 32 is not output. Under this state, carrier gas C1 can be used to purge the pipeline and the process chamber through which carrier gas C1 flows. Thus, carrier gas C1 is used as the purge gas.

When the fifth on-off valve 33 is off, and the sixth on-off valve 36 and the seventh on-off valve 37 are on, the carrier gas main route 31 is disconnected, and the first carrier gas branch 35a and the second carrier gas branch 35b are connected. Thus, carrier gas C1 can flow to the source bottle 32 through a front segment of the carrier gas main route 31 upstream of the fifth on-off valve 33 and the first carrier gas branch 35a. That is, carrier gas C1 can be output through the source bottle 32 to carry the precursor in the source bottle 32 and through the second carrier gas branch 35b and a rear segment of the carrier gas main route 31 downstream of the fifth on-off valve 33. Under this state, when the switching pipeline group 4 communicates the precursor source 30 with the gas inlet pipeline group 5, carrier gas C1 with the precursor can be transferred into the gas inlet pipeline group 5 and can be transferred to at least one of the two process chambers (2a, 2b) through the gas inlet pipeline group 5.

In some embodiments, the above fifth on-off valve 33, the sixth on-off valve 36, and the seventh on-off valve 37 are all fast-switching valves to achieve rapid on-off of the corresponding pipelines. Of course, in practical applications, other on-off valves can be used according to different process requirements, which are not limited in embodiments of the present disclosure.

In some embodiments, an intermediate pipeline 35c is also connected between the first carrier gas branch 35a and the second carrier gas branch 35b. A first automatic on-off valve 39c is arranged at the intermediate pipeline 35c. When the first automatic on-off valve 39c is on, the intermediate pipeline 35c can be connected. In this case, when the sixth on-off valve 36 and the seventh on-off valve 37 are on, carrier gas C1 does not pass through the source bottle 32, and the precursor in the source bottle 32 can be output and flow into the switching pipeline group 4. In addition, in some embodiments, a second automatic on-off valve 39a and a third automatic on-off valve 39b can be arranged at positions of the first carrier gas branch 35a and the second carrier gas branch 35b close to an input end and an output end of the source bottle 32, respectively, to realize the automatic control of the first carrier gas branch 35a and the second carrier gas branch 35b. A first manual valve 38a and a second manual valve 38b can be arranged at the first carrier gas branch 35a and the second carrier gas branch 35b, respectively. The automatic on-off valves and manual valves can be beneficial to improve the flexibility and reliability of the control. The first automatic on-off valve 39c, the second automatic on-off valve 39a, and the third automatic on-off valve 39b can be, for example, pneumatic valves.

In some embodiments, to ensure that there is a sufficient precursor in the source bottle 32 to meet the process requirements, the source bottle 32 also includes an injection end. The injection end can be configured to be connected to a liquid transfer system for supplying the liquid precursor. In some embodiments, the injection end, for example, can be connected to the liquid transfer system (not shown) through an injection pipeline 321. An eighth on-off valve 322 is arranged near the injection end of the injection pipeline 321.

It should be noted that, in some embodiments, the precursor source 30 can realize the supply of the precursor by using the source bottle 32 and carrier gas C1. However, embodiments of the present disclosure are not limited to this. In practical applications, the precursor source can further include any other gas supply structure, for example, a gas cabinet.

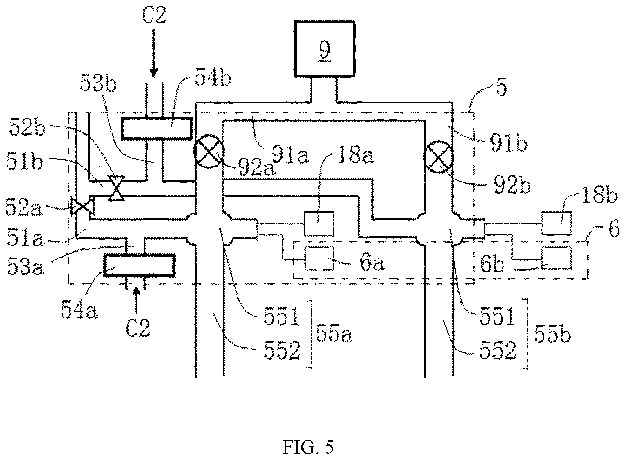

In some embodiments, as shown in FIG. 5, the gas inlet pipeline group 5 includes a first gas inlet branch 51a and a second gas inlet branch 51b. An outlet end of the first gas inlet branch 51a and an outlet end of the second gas inlet branch 51b communicate with the gas inlet structures 21 of the two process chambers (2a, 2b), respectively. In some embodiments, the outlet end of the first gas inlet branch 51a and the outlet end of the second gas inlet branch 51b communicate with the gas inlet structures 21 of the two process chambers (2a, 2b) through two gas mixing structures (55a, 55b). The two gas mixing structures (55a, 55b) can communicate with pipelines configured to transfer the precursor (with/or carrier gas) and other gases (e.g., dilution gas, balance gas, etc.), and introduce the gas independently or after mixing to the two process chambers (2a, 2b). Of course, in practical applications, according to the specific situation, the above gas mixing structures may not be provided. In this case, the outlet ends of the first gas inlet branch 51a and the second gas inlet branch 51b can directly communicate with the gas inlet structures 21 of the two process chambers (2a, 2b).

The gas inlet ends of the first gas inlet branch 51a and the second gas inlet branch 51b communicate with the gas outlet end of the switching pipeline group 4 (i.e., the first switching branch 41a shown in FIG. 3). Furthermore, as shown in FIG. 5, a first on-off valve 52a and a second on-off valve 52b are arranged at the first gas inlet branch 51a and the second gas inlet branch 51b, respectively. By selectively turning on at least one of the first on-off valve 52a and the second on-off valve 52b, at least one of the first gas inlet branch 51a and the second gas inlet branch 51b can be communicated to communicate the precursor source 30 with the at least one of the two process chambers (2a, 2b).

In embodiments of the present disclosure, each of the two gas mixing structures (55a, 55b) includes a first gas inlet end, a second gas inlet end, and a gas outlet end. The first gas inlet ends of the two gas mixing structures (55a, 55b) communicate with the gas outlet ends of the first gas inlet branch 51a and the second gas inlet branch 51b, respectively. The gas outlet ends of the two gas mixing structures (55a, 55b) communicate with the gas inlet structures 21 of the two process chambers (2a, 2b), respectively. The second gas inlet ends of the two gas mixing structures (55a, 55b) can be configured to be connected to a balance gas source for providing the balance gas and a reaction gas supply device 6.

In some embodiments, the second gas inlet ends of the two gas mixing structures (55a, 55b) are connected to the balance gas source through two balance gas transfer units (18a, 18b), respectively. The two balance gas transfer units (18a, 18b) can be configured to independently transfer the balance gas to the two process chambers (2a, 2b), respectively. When the deposition process is performed by alternately transferring the precursor to the two process chambers (2a, 2b), the gas inlet amount of the process chamber can fluctuate largely by stopping transferring the precursor at the moment of switching the two process chambers. Thus, the chamber pressure can fluctuate largely, the stability of the process gas flow field can be lowered. Therefore, at the moment of switching the two process chambers, the balance gas can start to be transferred to the process chamber to which transferring of the precursor is stopped to cause the gas inlet amount of the balance gas to be equal to the gas inlet amount of the precursor. Thus, the chamber pressure can be prevented from fluctuating largely due to the large fluctuation of the gas inlet amount. The stability of the process flow field can be increased. The balance gas can include, for example, argon (Ar) or another inert gas.

FIG. 3 and FIG. 5 only illustrate two balance gas transfer units (18a, 18b) without showing the specific structures of the two balance gas transfer units (18a, 18b). The specific structures can include balance gas inlet pipelines and on-off valves arranged at the balance gas inlet pipelines. Gas inlet ends of the balance gas inlet pipelines can be configured to be connected to the balance gas source, and gas outlet ends of the balance gas inlet pipelines can be connected to the corresponding gas mixing structures. In addition, flow controllers can also be arranged at the balance gas inlet pipelines to control the gas inlet volume in the balance gas inlet pipelines. Of course, in practical applications, the two balance gas transfer units (18a, 18b) can also be directly connected to the gas inlet structures 21 of the two process chambers (2a, 2b) without going through the gas mixing structures (55a, 55b).

In some embodiments, as shown in FIG. 3, the above reaction gas supply device 6 communicates with the gas inlet structures 21 of the two process chambers (2a, 2b) and is configured to simultaneously or separately supply the reaction gas to the two process chambers (2a, 2b). The plasma formed by the reaction gas (including but not limited to free radicals) can chemically react with the precursor adsorbed on wafer S to form desired film layer on the surface of wafer S. For example, if the to-be-deposited film material is silicon dioxide (SiO2), and SAM24 (Bis(diethylamino)silane) is used as the precursor, oxygen (O2) can be used as the reaction gas.

In embodiments of the present disclosure, optionally, the reaction gas supply device 6 includes a first reaction gas transfer unit 6a and a second reaction gas transfer unit 6b. Both the first reaction gas transfer unit 6a and the second reaction gas transfer unit 6b can communicate with the gas inlet structures 21 of the two process chambers (2a, 2b) through the two gas mixing structures (55a, 55b) and can be configured to independently transfer the reaction gas to the two process chambers (2a, 2b). FIG. 3 and FIG. 5 only schematically illustrate the first reaction gas transfer unit 6a and the second reaction gas transfer unit 6b without showing specific structures thereof. The specific structures can include reaction gas inlet pipelines and on-off valves arranged at the reaction gas inlet pipelines. Gas inlet ends of the reaction gas inlet pipelines can communicate with the reaction gas source, and gas outlet ends of the reaction gas inlet pipelines can communicate with the corresponding gas mixing structures. In addition, flow controllers can also be arranged at the reaction gas inlet pipelines to control the gas inlet volume in the reaction gas inlet pipelines. Of course, in practical applications, the first reaction gas transfer unit 6a and the second reaction gas transfer unit 6b can also directly communicate with the gas inlet structures 21 of the two process chambers (2a, 2b) without going through the gas mixing structures (55a, 55b).

Each gas mixing structure can have a plurality of structures. For example, in some embodiments, as shown in FIG. 5, each gas mixing structure includes a gas mixing block 551 and a gas mixing pipeline 552. The gas mixing block 551 includes a gas mixing cavity (not shown in the figure). The first gas inlet end, the second gas inlet end, and the gas outlet end are formed on the outer surface of the gas mixing block 551. The gas outlet end communicates with the gas inlet end of the gas mixing pipeline 552. The gas outlet end of the gas mixing pipeline 552 is used as the gas outlet end of the gas mixing structure and communicates with the gas inlet structure 21 of the process chamber. It should be noted that the number of the gas inlet ends of the gas mixing structure corresponds to the number of the process gases to be introduced into the process chamber. In practical applications, according to specific requirements, the balance gas and/or the reaction gas can also be introduced without passing through the gas mixing structure.

In some embodiments, as shown in FIG. 5, the gas inlet pipeline group 5 further includes a first dilution branch 53a and a second dilution branch 53b. Gas inlet ends of the first dilution branch 53a and the second dilution branch 53b both communicate with a dilution gas source (not shown in the figure) configured to provide a dilution gas. Gas outlet ends of the first dilution branch 53a and the second dilution branch 53b communicate with the first gas inlet branch 51a and the second gas inlet branch 51b, respectively. Moreover, a first flow controller 54a and a second flow controller 54b are arranged at the first dilution branch 53a and the second dilution branch 53b, respectively, and are configured to control the gas inlet volumes in the first dilution branch 53a and the second dilution branch 53b, respectively. The dilution gas output by the dilution gas source can flow into the first gas inlet branch 51a and the second gas inlet branch 51b through the first dilution branch 53a and the second dilution branch 53b, respectively, to be mixed with the precursor for dilution. The dilution gas can include, for example, Ar or another inert gas.

The radio frequency device 8 is connected to the two process chambers (2a, 2b) and is configured to selectively output radio frequency power to at least one of the process chambers (2a, 2b). In some embodiments of the present disclosure, as shown in FIG. 3, the radio frequency device 8 includes a first matcher 81a, a second matcher 81b, a first radio frequency generator 82a, and a second radio frequency generator 82b. The first radio frequency generator 82a is electrically connected to one of the process chambers (i.e., the first process chamber 2a) through the first matcher 81a, and the second radio frequency generator 82b is electrically connected to the other process chamber (i.e., the second process chamber 2b) through the second matcher 81b.

By separately providing the matchers and radio frequency generators for the two process chambers (2a, 2b), the radio frequency-related parameters (such as radio frequency power, frequency, ignition time, etc.) of the two process chambers (2a, 2b) can be individually adjusted, which adds process adjustment manners and improves process matching compatibility. Moreover, since the radio frequency generators of the two process chambers (2a, 2b) can be powered on at different times, the process steps do not need to be performed simultaneously in the two process chambers (2a, 2b), thereby improving process versatility. Moreover, there is no need to provide each chamber with a precursor supply device. By using the precursor supply device of embodiments of the present disclosure, the precursor can be introduced into the corresponding process chamber of the two process chambers at different times. That is, the precursor can be alternately transferred to the two process chambers (2a, 2b), which satisfies the requirements for process compatibility and reduces apparatus costs.

It should be noted that in some embodiments, the matchers and the radio frequency generators are provided for the two process chambers (2a, 2b), respectively. However, embodiments of the present disclosure are not limited to this. In practical applications, one matcher and one radio frequency generator can be provided, and a corresponding switch device can be arranged to selectively communicate the matcher and the radio frequency generator with one of the process chambers. Thus, the radio frequency power can be applied to the two process chambers (2a, 2b) at different times. The process steps do not need to be performed simultaneously in the two process chambers (2a, 2b), thereby improving the process versatility.

The pressure adjustment device 7 communicates with exhaust openings of the two process chambers (2a, 2b) and is configured to independently control the chamber pressures of the two process chambers (2a, 2b). Thus, when a difference exists between the thicknesses of the films deposited in the two process chambers (2a, 2b), the chamber pressures of the process chambers can be adjusted independently by the pressure adjustment device 7 to eliminate the difference to improve the flexibility of the process adjustment manner.

In some embodiments of the present disclosure, the pressure adjustment device 7 includes a first exhaust branch 71a and a second exhaust branch 71b. Gas inlet ends of the first exhaust branch 71a and the second exhaust branch 71b communicate with the exhaust openings of the two process chambers (2a, 2b). Gas outlet ends of the first exhaust branch 71a and the second exhaust branch 71b communicate with a gas pump device 10a. In addition, a first isolation valve 72a and a second isolation valve 72b are arranged at the first exhaust branch 71a and the second exhaust branch 71b, respectively, and are configured to independently control the on/off of the first exhaust branch 71a and the second exhaust branch 71b. A first flow adjustment valve 73a and a second flow adjustment valve 73b are arranged at the first exhaust branch 71a and the second exhaust branch 71b, respectively, and are configured to independently adjust the gas inlet volumes of the first exhaust branch 71a and the second exhaust branch 71b, respectively.

By setting the first isolation valve 72a and the second isolation valve 72b at the first exhaust branch 71a and the second exhaust branch 71b, respectively, physical isolation between the two process chambers (2a, 2b) can be truly realized. Thus, one of the process chambers has an abnormal situation such as fragments or increased particle count, the other process chamber can be avoided to be negatively affected. Meanwhile, by arranging the first flow adjustment valve 73a and the second flow adjustment valve 73b at the first exhaust branch 71a and the second exhaust branch 71b, the exhaust rates of the two process chambers (2a, 2b) can be independently controlled. Thus, when the difference exists in the thicknesses of the films deposited in the two process chambers (2a, 2b), the chamber pressures of the process chambers can be independently controlled by independently adjusting the first flow adjustment valve 73a and the second flow adjustment valve 73b to eliminate the difference. Thus, the flexibility of the process adjustment manner can be improved, and the process compatibility of the two process chambers can be further improved.

It should be noted that the pressure adjustment device 7 is not limited to the solution provided in the above embodiments. In practical applications, any other arbitrary structures can be used to realize the independent control of the chamber pressures in the process chambers.

It further needs to be noted that, in practical applications, the gas pump device 10a and the gas pump device 10b above can be the same gas pump device. That is, the switching pipeline group 4 and the two process chambers (2a, 2b) can share the same gas pump device. The gas pump device can be, for example, a vacuum pump.

In some embodiments, the plasma-enhanced atomic layer deposition apparatus further includes a remote plasma cleaning device 9, a first cleaning pipeline 91a, and a second cleaning pipeline 91b. Each of the gas mixing structures (55a, 55b) further includes a third gas inlet end. The gas inlet ends of the first cleaning pipeline 91a and the second cleaning pipeline 91b communicate with the remote plasma cleaning device 9. The gas outlet ends of the first cleaning tube 91a and the second cleaning tube 91b communicate with the third gas inlet ends of the two mixing structures (55a, 55b). Of course, in practical applications, according to specific situations, the gas outlet ends of the first cleaning pipeline 91a and the second cleaning pipeline 91b can also directly communicate with the gas inlet structures 21 of the two process chambers (2a, 2b).

Moreover, a third isolation valve 92a and a fourth isolation valve 92b are arranged at the gas outlet ends of the first cleaning pipeline 91a and the second cleaning pipeline 91b, respectively. The remote plasma cleaning device 9 can be configured to provide a plasma (e.g., plasma formed by ionizing NF₃ gas) capable of cleaning the process chamber to at least one of the two process chambers (2a, 2b) after the films in the two process chambers (2a, 2b) are accumulated to a certain thickness.

With the third isolation valve 92a and fourth isolation valve 92b, any one process chamber can be cleaned independently, or the two process chambers can be cleaned simultaneously. Thus, the flexibility of the cleaning manner can be improved. Meanwhile, when the deposition process is performed, the process gas can be prevented from diffusing to the remote plasma cleaning device 9 by closing the third isolation valve 92a and the fourth isolation valve 92b. Thus, the utilization rate of the process gas can be improved, and the stability of the process gas flow field can be improved.

It needs to be noted that in practical applications, the remote plasma cleaning device 9 may not be included according to actual needs.

As another technical solution, embodiments of the present disclosure also provide a plasma-enhanced atomic layer deposition method. In the method, the plasma-enhanced atomic layer deposition apparatus of embodiments of the present disclosure can be used to deposit film layers on the two wafers simultaneously.

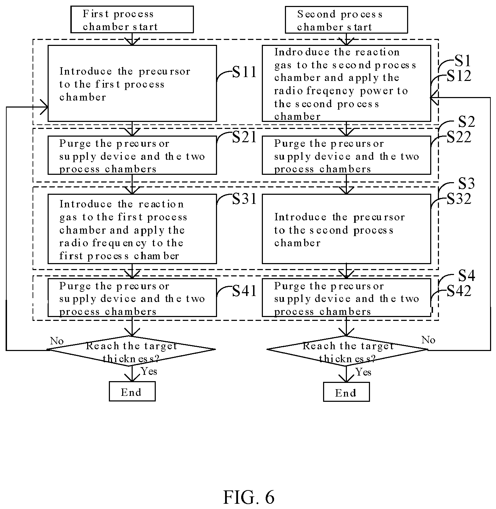

In some embodiments, taking the plasma-enhanced atomic layer deposition apparatus shown in FIG. 3 as an example, as shown in FIG. 6, the plasma-enhanced atomic layer deposition method includes the following processes.

At S1, step S11 and step S12 are performed in the two process chambers (2a, 2b) and are performed simultaneously or at different times.

At S11, the precursor is introduced into the first process chamber 2a to cause the precursor to be adsorbed on the surface of wafer S.

At S12, the reaction gas is introduced into the second process chamber 2b, and the radio frequency power is applied to the second process chamber to excite the reaction gas to form the plasma. The plasma can react with the precursor adsorbed at the surface of wafer S to form the required film layer on the surface of wafer S.

In some embodiments, taking the plasma-enhanced atomic layer deposition apparatus shown in FIGS. 2 to 5 as an example, during the process of performing step S11 and step S 12, the fourth on-off valve 42b, the fifth on-off valve 33, and the second on-off valve 52b are closed, while the third on-off valve 42a, the sixth on-off valve 36, the seventh on-off valve 37, and the first on-off valve 52a are opened to introduce the precursor (carried by carrier gas C1) independently into the first process chamber 2a. It should be noted that during step S11, the time for introducing the precursor into the first process chamber 2a is generally short and shorter than the process duration of step S11. In this case, the third on-off valve 42a is not continuously kept open during step S 11. For example, at the beginning of step S 11, the third on-off valve 42a is opened while the fourth on-off valve 42b is closed. Then, the precursor is introduced into the first process chamber 2a. After a certain time (not reaching the process time of step S11), the third on-off valve 42a is closed, while the fourth on-off valve 42b is opened. Thus, the precursor can flow into the gas pump device 10b through the second switching branch 41b, In practical applications, the third on-off valve 42a can be caused to stay open when performing step S11 according to different needs, which is not limited in embodiments of the present disclosure.

At the same time, in some embodiments, the dilution gas can be introduced into the two process chambers (2a, 2b) simultaneously by using the first dilution branch 53a and the second dilution branch 53b. The balance gas can be introduced into the second process chamber 2b by using the balance gas transfer unit 18b to ensure the numbers of the gas inlets of the two process chambers (2a, 2b) are equal. The reaction gas can be introduced to the second process chamber 2b by using the second reaction gas transfer unit 6b, and the second radio frequency generator 82b can be opened. Thus, the radio frequency power can be applied to the second process chamber 2b through the second macher 81b to excite the reaction gas to form the plasma.

At S2, step S21 and step S22 are performed in the two process chambers (2a, 2b), respectively, and can be performed simultaneously or at different times.

Step S21 and step S22 are used to purge the precursor supply device and the two process chambers (2a, 2b) of the plasma-enhanced atomic layer deposition apparatus.

In some embodiments, taking the plasma-enhanced atomic layer deposition apparatus shown in FIGS. 2 to 5 as an example, during the process of performing step S21 and step S22, the fourth on-off valve 42b, the fifth on-off valve 33, the first on-off valve 52a, the second on-off valve 52b, and the third on-off valve 42a are opened, while the sixth on-off valve 36 and the seventh on-off valve 37 are closed to purge the corresponding pipelines and the two process chambers (2a, 2b).

At the same time, in embodiments of the present disclosure, the first dilution branch 53a and the second dilution branch 53b can be configured to simultaneously introduce the dilution gas into the two process chambers (2a, 2b), which is also used for purging. The two balance gas transfer units (18a, 18b) can be configured to simultaneously introduce the balance gas into the first process chamber 2a and the second process chamber 2b, respectively, for purging. The reaction gas can be stopped to be introduced into the second process chamber 2b.

At S3, step S31 and step S32 are performed in the two process chambers (2a, 2b), respectively, and are performed simultaneously or at different times.

At S31, the reaction gas is introduced into the first process chamber 2a, and the radio frequency power is applied to the first process chamber 2a to excite the reaction gas to form the plasma. The plasma can react with the precursor adsorbed on the surface of wafer S to form the desired film layer on wafer S.

At S32, the precursor is introduced into the second process chamber 2b to allow the precursor to be adsorbed onto the surface of wafer S.

In some embodiments, taking the plasma-enhanced atomic layer deposition apparatus shown in FIGS. 2 to 5 as an example, during the process of performing step S31 and step S32, the fourth on-off valve 42b, the fifth on-off valve 33, and the first on-off valve 52a are closed, while the third on-off valve 42a, the sixth on-off valve 36, the seventh on-off valve 37, and the second on-off valve 52b are opened to introduce the precursor (carried by carrier gas C1) into the second process chamber 2b.

At the same time, in embodiments of the present disclosure, the dilution gas can be simultaneously introduced into the two process chambers (2a, 2b) by using the first dilution branch 53a and the second dilution branch 53b. The balance gas can be introduced into the first process chamber 2a by using the balance gas transfer unit 18a to ensure the gas inlet volumes of the two process chambers (2a, 2b) are equal. The reaction gas can be introduced into the first process chamber 2a by using the first reaction gas transfer unit 6a, and the first radio frequency generator 82a is turned on to supply the radio frequency power to the first process chamber 2a through the first matcher 81a. Thus, the reaction gas can be excited to form the plasma.

At S4, step S41 and step S42 are performed in the two process chambers (2a, 2b), respectively, and are performed simultaneously or at different times.

Step S41 and step S42 are similar to the above step S21 and step S22 and are not repeated here.

Step S1 to step S4 are repeated in a cycle until the thickness of the film layer deposited on the two wafers reaches the target thickness.

In the plasma-enhanced atomic layer deposition method of embodiments of the present disclosure, the process steps may not need to be performed simultaneously in the two process chambers (2a, 2b). Thus, the process versatility can be improved. Moreover, there is no need to provide the precursor supply device for each chamber, and the precursor can be introduced into one of the process chambers at different times by using the precursor supply device of embodiments of the present disclosure. That is, the precursor can be transferred to the two process chambers (2a, 2b) alternatively, which satisfies the requirements for process compatibility and reduces the apparatus costs.

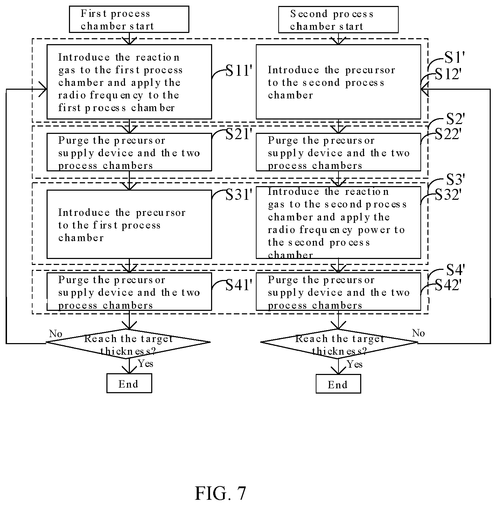

Embodiments of the present disclosure also provide a plasma-enhanced atomic layer deposition method. In some embodiments, as shown in FIG. 7, the method includes steps S1' to S4'.

At S 1', step S11' and step S 12' are performed in the two process chambers (2a, 2b), respectively, and are performed simultaneously or at different times.

At step S11', the reaction gas is introduced into the first process chamber 2a, and the radio frequency power is applied to the first process chamber 2a to excite the reaction gas to form the plasma. The plasma can react with the precursor adsorbed on the surface of wafer S to form the desired film layer on the surface of wafer S.

At S12', the precursor is introduced into the second process chamber 2b to allow the precursor to be adsorbed onto the surface of wafer S.

In some embodiments, taking the plasma-enhanced atomic layer deposition apparatus shown in FIGS. 2 to 5 as an example, during the process of performing step S 11' and step S 12', the fourth on-off valve 42b, the fifth on-off valve 33, and the first on-off valve 52a are closed, while the third on-off valve 42a, the sixth on-off valve 36, the seventh on-off valve 37, and the second on-off valve 52b are opened to separately introduce the precursor (carried by carrier gas C1) into the second process chamber 2b.

At the same time, in embodiments of the present disclosure, the dilution gas can be introduced into the two process chambers (2a, 2b) by using the first dilution branch 53a and the second dilution branch 53b. The balance gas can be introduced into the first process chamber 2a by using the balance gas transfer unit 18a to ensure the gas inlet volumes in the two process chambers (2a, 2b) are equal. The reaction gas can be introduced into the first process chamber 2a by using the first reaction gas transfer unit 6a, and the first radio frequency generator 82a is turned on to supply the radio frequency power to the first process chamber 2a through the first matcher 81a to excite the reaction gas to form the plasma.

At S2', step S21' and step S22' are performed in the two process chambers (2a, 2b), respectively, and are performed simultaneously or at different times.

Step S21' and step S22' are used to purge the precursor supply device and the two process chambers (2a, 2b) of the plasma-enhanced atomic layer deposition apparatus.

In some embodiments, taking the plasma-enhanced atomic layer deposition apparatus shown in FIGS. 2 to 5 as an example, during the process of performing step S21' and step S22', the fourth on-off valve 42b, the fifth on-off valve 33, the first on-off valve 52a, the second on-off valve 52b, and the third on-off valve 42a are opened, while the sixth on-off valve 36 and the seventh on-off valve 37 are closed to purge the corresponding pipelines and the two process chambers (2a, 2b).

At the same time, in embodiments of the present disclosure, the dilution gas can be simultaneously introduced into the two process chambers (2a, 2b) by using the first dilution branch 53a and the second dilution branch 53b for purging. The balance gas can be introduced into the first process chamber 2a and the second process chamber 2b by using the balance gas transfer units (18a, 18b), respectively, for purging. The reaction gas can be stopped from being introduced into the second process chamber 2b.

At S3', step S31' and step S32' are performed in the two process chambers (2a, 2b), respectively, and are performed simultaneously or at different times.

At S31', the precursor is introduced into the first process chamber 2a to allow the precursor to be adsorbed onto the surface of wafer S.

At S32', the reaction gas is introduced into the second process chamber 2b, and the radio frequency power is applied to the second process chamber 2b to excite the reaction gas to form the plasma. The plasma can react with the precursor adsorbed on the surface of wafer S to form the desired film layer on the surface of wafer S.

In some embodiments, taking the plasma-enhanced atomic layer deposition apparatus shown in FIGS. 2 to 5 as an example, during the process of performing step S31' and step S32', the fourth on-off valve 42b, the fifth on-off valve 33, and the second on-off valve 52b are closed, while the third on-off valve 42a, the sixth on-off valve 36, the seventh on-off valve 37, and the first on-off valve 52a are opened to introduce the precursor (carried by carrier gas C1) into the first process chamber 2a.

At the same time, in embodiments of the present disclosure, the dilution gas is introduced into the two process chambers (2a, 2b) by using the first dilution branch 53a and the second dilution branch 53b. The balance gas can be introduced into the second process chamber 2b by using the balance gas transfer unit 18b to ensure the gas inlet volumes of the two process chambers (2a, 2b) are equal. The reaction gas can be introduced into the second process chamber 2b by using second reaction gas transfer unit 6b, and the second radio frequency generator 82b is turned on to supply the radio frequency power to the second process chamber 2b through the second matcher 81b to excite the reaction gas to form the plasma.

At S4', step S41' and step S42' are performed in the two process chambers (2a, 2b), respectively, and are performed simultaneously or at different times.

Step S41' and step S42' are similar to step S21' and step S22' and are not repeated here.

Step S1' to step S4' are repeated in a cycle until the thicknesses of the film layers deposited on the two wafers reach the target thickness.

In summary, embodiments of the present disclosure provide the plasma-enhanced atomic layer deposition apparatus and method. By using the pressure adjustment device communicating with the exhaust openings of the two process chambers, the chamber pressures of the two process chambers can be independently controlled. Furthermore, by using the radio frequency device connected to the two process chambers, the radio frequency power can be selectively output to at least one of the process chambers. Thus, the radio frequency-related parameters of the process chambers can be adjusted independently, which increases the process adjustment manners and improves the process compatibility. Moreover, the process steps do not need to be performed simultaneously in the two process chambers, which improves the process versatility, and there is no need to provide the precursor supply device for each chamber. That is, the precursor supply device can communicate with the gas inlet structures of the two process chambers to selectively provide the precursor or the purge gas to the at least one process chamber of the two process chambers. Thus, the apparatus costs can be reduced.

It should be understood that the above embodiments are merely illustrative examples for explaining the principles of the present disclosure. The present disclosure is not limited to this. Those skilled in the art can make various modifications and improvements without departing from the spirit and scope of the present disclosure. Such modifications and improvements are within the scope of the present disclosure.

## Claims

1. A plasma-enhanced atomic layer deposition apparatus, comprising two process chambers, a precursor supply device, a reaction gas supply device, a radio frequency device, and a pressure adjustment device, wherein:
the precursor supply device communicates with gas inlet structures of the two process chambers and is configured to selectively provide a precursor or a purge gas to at least one of the two process chambers;
the reaction gas supply device communicates with the gas inlet structures of the two process chambers and is configured to selectively provide a reaction gas to at least one of the two process chambers;
the radio frequency device is connected to the two process chambers and is configured to selectively output radio frequency power to at least one of the two process chambers; and
the pressure adjustment device communicates with exhaust openings of the two process chambers and is configured to independently control chamber pressures of the two process chambers.

2. The plasma-enhanced atomic layer deposition apparatus according to claim 1, wherein the precursor supply device includes a precursor source, a gas inlet pipeline group, a switching pipeline group, and a gas pump device, wherein:
the precursor source communicates with the gas inlet pipeline group through the switching pipeline group, and the gas inlet pipeline group communicates with the gas inlet structures of the two process chambers;
the precursor source is configured to provide the precursor or purge gas;
the switching pipeline group is configured to selectively communicate the precursor source to the gas inlet pipeline group or the gas pump device; and
the gas inlet pipeline assembly is configured to selectively communicate the precursor source to at least one of the two process chambers.

3. The plasma-enhanced atomic layer deposition apparatus according to claim 2, wherein the gas inlet pipeline group includes a first gas inlet branch and a second gas inlet branch, wherein:
a gas outlet end of the first gas inlet branch and a gas outlet end of the second gas inlet branch communicate with the gas inlet structures of the two process chambers, respectively;
a gas inlet end of the first gas inlet branch and a gas inlet end of the second gas inlet branch communicate with the switching pipeline group;
a first on-off valve and a second on-off valve are arranged at the first gas inlet branch and the second gas inlet branch, respectively.

4. The plasma-enhanced atomic layer deposition apparatus according to claim 3, wherein the gas inlet pipeline group further includes a first dilution branch and a second dilution branch, wherein gas inlet ends of the first dilution branch and the second dilution branch communicate with a dilution gas source configured to provide the dilution gas, respectively, gas outlet ends of the first dilution branch and the second dilution branch communicate with a first gas inlet branch and a second gas inlet branch, respectively, and a first flow controller and a second flow controller are arranged at the first dilution branch and the second dilution branch.

5. The plasma-enhanced atomic layer deposition apparatus according to claim 3, wherein the gas inlet pipeline group further includes two gas mixing structures, wherein each of the two mixing structures has a first gas inlet end, a second gas inlet end, and a gas outlet end, the first gas inlet ends of the two mixing structures communicate with the gas outlet ends of the first gas inlet branch and the second gas inlet branch, the gas outlet ends of the two gas mixing structures communicate with the gas inlet structures of the two process chambers, respectively, and the second gas inlet ends of the two gas mixing structures communicate with a balance gas source configured to provide a balance gas and a reaction gas supply device, respectively.

6. The plasma-enhanced atomic layer deposition apparatus according to claim 5, wherein each of the mixing structures includes a gas mixing block and a gas mixing pipeline, the gas mixing block has a mixing chamber, and the first gas inlet end and the second gas inlet end are formed on an outer surface of the gas mixing block, a gas outlet end is formed on the outer surface of the gas mixing block, the gas outlet end communicates with a gas inlet end of the gas mixing pipeline, and the gas outlet end of the gas mixing pipeline is used as the gas outlet end of the gas mixing structure to communicate with the gas inlet structure of the process chamber.

7. The plasma-enhanced atomic layer deposition apparatus according to any one of claims 2 to 6, wherein the switching pipeline group includes a first switching branch and a second switching branch, two ends of the first switching branch communicate with the precursor source and the gas inlet pipeline group, respectively, two ends of the second switching branch communicate with the first switching branch and the gas pump device, and a third on-off valve and a fourth on-off valve are arranged at the first switching branch and the second switching branch.

8. The plasma-enhanced atomic layer deposition apparatus according to any one of claims 2 to 6, wherein the precursor source includes a carrier gas main route, a source bottle, a first carrier gas branch, and a second carrier gas branch, wherein:
a gas inlet end of the carrier gas main route communicates with a carrier gas source for providing a carrier gas, a gas outlet end of the carrier gas main route communicates with the switching pipeline group, and a fifth on-off valve and a third flow controller are arranged at the carrier gas main route;
a gas inlet end of the first carrier gas branch communicates with the carrier gas main route at an upstream position of the fifth on-off valve, and a gas outlet end of the first carrier gas branch communicates with a gas inlet end of the source bottle, a gas outlet end of the second carrier gas branch communicates with the carrier gas main route at a downstream position of the fifth on-off valve, a gas inlet end of the second carrier gas branch communicates with the gas outlet end of the source bottle, and a sixth on-off valve and a seventh on-off valve are arranged at the first carrier gas branch and the second carrier gas branch; and
the source bottle is configured to store the precursor.

9. The plasma-enhanced atomic layer deposition apparatus according to claim 1, wherein the radio frequency device includes a first matcher, a second matcher, a first radio frequency generator, and a second radio frequency generator, wherein the first radio frequency generator is electrically connected to one of the process chambers through the first matcher, and the second radio frequency generator is electrically connected to the other one of the process chambers through the second matcher.

10. The plasma-enhanced atomic layer deposition apparatus according to claim 1, wherein the pressure adjustment device includes a first exhaust branch and a second exhaust branch, wherein gas inlet ends of the first exhaust branch and the second exhaust branch communicate with exhaust openings of the two process chambers, respectively, gas outlet ends of the first exhaust branch and the second exhaust branch communicate with the gas pump device, a first isolation valve and a second isolation valve are arranged at the first exhaust branch and the second exhaust branch, respectively, and a first flow adjustment valve and a second flow adjustment valve are arranged at the first exhaust branch and the second exhaust branch.

11. The plasma-enhanced atomic layer deposition apparatus according to claim 5 or 6, wherein the plasma-enhanced atomic layer deposition apparatus further includes a remote plasma cleaning device, a first cleaning pipeline, and a second cleaning pipeline, and each of the two gas mixing structures includes a third gas inlet end, gas inlet ends of the first cleaning pipeline and the second cleaning pipeline communicate with the remote plasma cleaning device, gas outlet ends of the first cleaning pipeline and the second cleaning pipeline communicate with the two third gas inlet ends, and a third isolation valve and a fourth isolation valve are arranged at the first cleaning pipeline and the second cleaning pipeline, respectively; and
the remote plasma cleaning device is configured to provide a plasma for cleaning the process chamber.

12. A plasma-enhanced atomic layer deposition method, using the plasma-enhanced atomic layer deposition apparatus according to any one of claims 1 to 11 to simultaneously deposit film layers on two wafers, comprising:
at S1, introducing the precursor into a first process chamber of the two process chambers, introducing the reaction gas into a second process chamber of the two process chambers, and applying the radio frequency power to the second process chamber;
at S2, purging the precursor supply device and the two process chambers;
at S3, introducing the precursor into the second process chamber, introducing the reaction gas into the first process chamber, and applying the radio frequency power to the first process chamber;
at S4, purging the precursor supply device and the two process chambers; and
repeating steps S1 to S4 in a cycle until the thicknesses of the deposited film layers on the two wafers reach a target thickness.
